(19)

(11) **EP 2 558 875 B1**

(12) # EUROPÄISCHE PATENTSCHRIFT

(45) Veröffentlichungstag und Bekanntmachung des Hinweises auf die Patenterteilung:
**12.02.2014 Patentblatt 2014/07**

(21) Anmeldenummer: **10715781.0**

(22) Anmeldetag: **14.04.2010**

(51) Int Cl.:
***G01R 33/07*** *(2006.01)* ***G01R 33/00*** *(2006.01)*
***H01F 27/38*** *(2006.01)* ***H01F 27/40*** *(2006.01)*

(86) Internationale Anmeldenummer:
**PCT/EP2010/054857**

(87) Internationale Veröffentlichungsnummer:
**WO 2011/127969 (20.10.2011 Gazette 2011/42)**

(54) **VERFAHREN UND VORRICHTUNG ZUM DETEKTIEREN EINER MAGNETISCHEN KENNGRÖSSE IN EINEM KERN**

METHOD AND APPARATUS FOR DETECTING A MAGNETIC CHARACTERISTIC VARIABLE IN A CORE

PROCÉDÉ ET DISPOSITIF POUR LA DÉTECTION D'UNE GRANDEUR MAGNÉTIQUE CARACTÉRISTIQUE DANS UN NOYAU

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**20.02.2013 Patentblatt 2013/08**

(73) Patentinhaber: **Siemens AG Österreich**
**1210 Wien (AT)**

(72) Erfinder:
- **HAMBERGER, Peter**
  **A-4202 Kirchschlag (AT)**
- **LEIKERMOSER, Albert**
  **A-5020 Salzburg (AT)**

(74) Vertreter: **Maier, Daniel Oliver**
**Siemens AG**
**Postfach 22 16 34**
**80506 München (DE)**

(56) Entgegenhaltungen:
**WO-A1-01/43267**
**WO-A1-2008/151661**
**DE-A1-102006 037 003**
**JP-A- 57 043 406**
**US-A- 3 863 109**
**US-A1- 2007 159 284**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

**Beschreibung**

Technisches Gebiet

Die Erfindung betrifft ein Verfahren und eine Vorrichtung zum Detektieren einer magnetischen Kenngröße, insbesondere der magnetischen Feldstärke in einem Abschnitt eines von einem magnetischen Fluss durchflossenen Kerns.

Stand der Technik

Bei elektrischen Transformatoren, wie sie in Energie-Verteilungsnetzen verwendet werden, kann aufgrund des verstärkten Einsatzes leistungselektronischer Baukomponenten, wie sie beispielsweise in Zusammenhang mit elektrischen Antrieben oder Blindleistungskompensationsanlagen eingesetzt werden, eine Stromkomponente entstehen, die bezüglich des Netzes als Gleichstrom anzusehen ist. Dieser Gleichstrom oder "DC-Anteil" beträgt zwar meist nur einige Promille des Transformator-Nennstroms, bewirkt aber im Kern des Transformators einen magnetischen Gleichfluss, der sich dem Wechselfluss überlagert.

Auch durch sogenannte "Gomagnetically Induced Currents" (GIC) kann es in einem Transformatorkern zur Ausbildung eines Gleichfluss-Anteils kommen.

Moderne Kernwerkstoffe haben eine sehr hohe magnetische Permeabilität und Kerne werden in Step-Lap-Schichtverfahren erzeugt. Dadurch haben Trafokerne eine sehr hohe magnetische Leitfähigkeit und üblicherweise wird der magnetische Werkstoff eines Transformatorkerns mit einer hohen Ausnutzung betrieben, was den Transformator besonders empfindlich gegen Gleichfelder macht.

Bereits moderate Gleichstromamperewindungen können eine solche Unsymmetrie bei der Aussteuerung der BH- Kennlinie verursachten, so dass die Flussdichte jeweils in einer Halbperiode nahe der Sättigungsflussdichte des Kernwerkstoffs kommt. Der Magnetisierungsstrom ist dadurch nicht mehr sinusförmig, sondern verzerrt. Es erhöht sich die Temperatur im Kern und in der elektrischen Wicklung. Bei Betrieb tritt eine erhöhte Geräuschentwicklung auf, was insbesondere dann von Nachteil ist, wenn ein Transformator in der Nähe eines Wohnbereichs zu installieren ist.

Um Betriebsgeräusche bei einem Transformator zu verringern, wird in der DE 40 21 860 C 2 eine Geräuschmessung am Transformator vorgeschlagen. In Abhängigkeit der Geräusche des Transformators speist ein Gleichstromerzeuger in eine Kompensationswicklung des Transformators einen Kompensationsstrom ein, so dass die Betriebsgeräusche verringert werden. Die Geräuschmessung ist aber aufwändig und störanfällig.

Grundsätzlich könnte man bei einem Leistungstransformator den Gleichfluss-Anteil auch durch Stromwandler ermitteln, indem die in den Primärwicklungen und Sekundärwicklungen fließenden Ströme gemessen werden und aus dem Messsignal Anteile der geradzahligen Harmonischen , welche mit dem magnetischen Gleichfluss im Kern korrelieren, herausgefiltert werden. Von Nachteil ist hierbei aber, dass die Stromwandler in einem Bereich hoher Spannungspotentiale zu installieren sind, was im Zusammenhang mit dem hohen Isolationsaufwand kostspielig ist.

Eine andere Möglichkeit bestünde darin, den Gleichfeld-Anteil durch die Bestimmung der spektralen Anteile von geradzahligen Harmonischen in den Spannungssignalen herauszufiltern. Diese Amplitude der geradzahligen Harmonischen liegt aber verglichen mit der netzfrequenten Grundschwingung nur im Promillebereich, was die Messdatenverarbeitung aufwändig macht.

Darüber hinaus ergeben sich bezüglich der Zuverlässigkeit eines solchen Messsystems besondere Anforderungen, da ein Leistungstransformator stets für einen sehr langen Betriebszeitraum ausgelegt ist und ein sehr geringer Wartungsaufwand angestrebt wird. Es versteht sich von selbst, dass ein Messsystem zur Detektion eines Gleichanteils sowohl die Auslegung des magnetischen Kerns als auch der elektrischen Wicklung und anderer mechanischer Baukomponenten möglichst unbeeinflusst lassen soll.

Die PCT/EP2007/055728 beschreibt einen Transformator mit Gleichfluss-Kompensation, wobei nach Maßgabe einer Magnetfeldmessung ein Kompensationsstrom so vorgegeben wird, dass der Gleichanteil gemindert wird. Das Magnetfeld wird mittels einer am Transformatorkern angeordnete Sensorspule gemessen. Die Messspule ist zuverlässig, die Verarbeitung des Messsignals erfordert aber aufgrund der Signalschwäche des Sensorsignals einerseits sehr aufwändige Hardwarekomponenten zur Signalkonditionierung und darüber hinaus sehr komplexe Signalverarbeitungsalgorithmen.

Eine allseits zufriedenstellende Detektion eines Gleichanteils in einem Kern ist allerdings bislang nicht bekannt. Weitere relevante Patent-Publicationen sind JP570434006, US2007/159284, WO2008/151661, DE102006037003, US3863109 und WO01/43267.

Darstellungen der Erfindung

Es ist eine Aufgabe der vorliegenden Erfindung einen Ansatz zu schaffen, der auf möglichst einfache Art und Weise eine zuverlässige Detektion einer unsymmetrischen Kernaussteuerung ermöglicht.

Diese Aufgabe wird für ein Verfahren mit den Merkmalen des Patentanspruchs 1 und für eine Vorrichtung mit den Merkmalen des Patentanspruchs 10 gelöst. Vorteilhafte Ausgestaltungen der Erfindung sind in den jeweils abhängigen Ansprüchen definiert.

Die Erfindung geht einen neuen Weg bei der Erfassung der physikalischen Größe, welche die unsymmetrische Aussteuerung des magnetischen Werkstoffs verursacht. Gemäß der Erfindung kommt eine Sensoreinrichtung zum Einsatz, welche nach Art eines "magnetischen Bypass" arbeitet: mittels eines ferromagnetischen Nebenschluss-Teils wird ein Teil des magnetischen Hauptflusses am Transformatorkern abgezweigt und stromabwärts wieder zugeführt. Aus diesem abgezweigten und in Nebenschluss zum Kern geführten Flussanteil wird entweder direkt, oder indirekt aus einer davon abgeleiteten physikalischen Größe, die magnetische Feldstärke im vom Nebenschlusszweig überbrückten Kernabschnitt ermittelt. Durch diese Erfassung der magnetischen Feldstärke, im Folgenden auch als magnetische Erregung bezeichnet, ergibt sich eine Reihe von Vorteilen. Zum einen verringert sich der signaltechnische Aufwand, um einen Gleichfeld-Anteil in einem Weichmagnetischen Kern zu ermitteln, da bekanntlich bei einer beginnenden Sättigung im Transformatorkern der Anteil des Streuflusses steigt. Das heißt, bei jeder Halbperiode, bei der das magnetische Material des Kerns (Messobjekte) im vom Nebenschluss-Teil (Sensor) überbrückten Bereich aufgrund der Unsymmetrie in die Sättigung gerät, erhöht sich aufgrund der prinzipbedingt wesentlich höheren magnetischen Sättigungsgrenze des Nebenschluss-Teils der im Nebenschlusszweig geführte Flussanteil in Relation zum Hauptfluss im Messobjekt. Mit anderen Worten, erfindungsgemäß wurde der Vorteil des technischen Effektes erkannt, dass es für die Detektion einer magnetischen Kenngröße in einem Abschnitt des Kerns günstig ist, wenn der Nebenschlusszweig, auch im Falle starker magnetischer Sättigung im Bereich des vom Nebenschluss-Teil (Sensor) überdeckten Abschnittes des Kerns (Messeobjekt), selbst noch keinerlei magnetische Sättigungseffekte zeigt und sein "magnetischer Widerstand", also im Wesentlichen die effektive Permeabilität des magnetischen Nebenschlusses, weitgehend von der Sättigungssituation des Messobjektes unbeeinflusst und konstant bleibt. Dieser Effekt kann auf unterschiedliche Art und Weise erwirkt werden.

In einer bevorzugten Ausgestaltung des erfindungsgemäßen Verfahrens wird der abgezweigte magnetischen Flusses über zumindest einen nicht ferromagnetischen Spalt, im Folgenden auch der Anschaulichkeit wegen als "Luftspalt" bezeichnet, geführt. Dadurch ist es möglich die magnetische Sättigungsgrenze zu erhöhen und obendrein eine linearisierende Wirkung auf die effektive Permeabilität des gesamten Nebenschlusszweiges und damit auf die Messgenauigkeit zu entfalten. Im Ergebnis erreicht man, dass selbst im Falle starker magnetischer Sättigung des Kerns, der Magnetwerkstoff des Nebenschluss-Teils noch immer frei von magnetischen Sättigungseffekten ist und dieser abgezweigte magnetische Flussanteil direkt proportional zur magnetischen Erregung des überwachten Bereichs des Messobjektes ist.

In einer anderen bevorzugten Ausführungsform kann vorgesehen sein, dass der Nebenschlusszweig, über den der abgezweigte Teile des magnetischen Flusses geführt wird, eine effektive Permeabilität aufweist, die kleiner ist als die Permeabilität des weichmagnetischen Kernwerkstoffs. Dadurch wird ebenfalls erreicht, dass selbst im Falle starker magnetischer Sättigung des Kerns, der Nebenschluss-Teil noch immer frei von magnetischen Sättigungseffekten ist und dessen magnetische Fluss direkt proportional zur magnetischen Erregung des überwachten Bereichs des Messobjektes ist. In einer weiteren Fortbildung dieser Ausführungsform kann vorgesehen sein, dass der abgezweigte magnetische Fluss über einen nicht ferromagnetischen Spalt geführt wird. Der Nebenschlusszweig wird dadurch bezüglich Sättigungseffekten noch unempfindlicher.

Mit Vorteil ist der magnetische Nebenschluss-Teil mit einer Messeinrichtung versehen, mittels derer der abgezweigte magnetische Fluss im Nebenschlusszweig gemessen wird. Technisch einfach kann dies durch eine Sensorspule realisiert sein, die am Nebenschluss-Teil angeordnet ist. In dieser Sensorspule wird bei zeitlicher Änderung des die Sensorspule durchsetzenden abgezweigten magnetischen Flussanteils ein Sensorsignal induziert. Es kann aber auch ein anderer Magnetfelddetektor, beispielsweise ein Hallsensor verwendet werden.

Zum Zwecke der Auswertung wird das Sensorsignal einer Auswerteeinrichtung zugeführt. In der Auswerteeinrichtung kann dann aus dem Sensorsignal beispielsweise der Gleichanteil eines magnetischen Flusses im Kern eines Transformators ermittelt werden.

Für die Auswertung ist es günstig, wenn mittels eines Kerbfilters zunächst ein niederfrequenter Grundschwingungsanteil eliminiert wird, das Sensorsignal dann digitalisiert wird, wobei in äquidistanten Zeitpunkten mit einer Abtastfrequenz abgetastet wird, die einem ganzzahligen vielfachen der Netzfrequenz des Transformators entspricht.

Für die Signalverarbeitungseinheit kann es günstig sein, wenn digitale Signalwerte mit einem jeweils eine halbe Periodendauer der Netzfrequenz zurückliegenden digitale Signalwerte addiert werden.

Hierbei ist von Vorteil, wenn aus den digitalen Signalwerten mittels eines Bandpass-Filters Signalanteile mit doppelter Netzfrequenz herausgefiltert werden und die herausgefilterten Signalwerte einer Fourier-Transformation unterzogen werden.

Die Aufgabe wird auch durch Bereitstellung einer Vorrichtung gelöst, welche einen magnetischen Nebenschluss-Teil aufweist, der einen vom Kern abgezweigten Teil des magnetischen Flusses führt, wobei der Magnetwerkstoff des Nebenschluss-Teils nicht gesättigt wird, und welche eine Sensor- und Auswerteeinrichtung aufweist, die dazu eingerichtet ist, um aus diesen abgezweigten Teil des magnetischen Flusses oder einer davon abgeleiteten Größe dem magnetische Feldstärke im Abschnitt zu ermitteln.

Eine hinsichtlich der Zuverlässigkeit günstige Ausführungsform der Erfindung kann darin bestehen, dass ein oder mehrere Abschnitte des magnetischen Nebenschluss-Teils mit mindestens einer Sensorspule umwickelt sind, in welcher durch Induktion ein Sensorsignal erzeugt wird und daraus mittels einer Auswerteeinrichtung der Gleichanteil ermittelt wird. Es werden keine aktiven Baukomponenten benötigt, die Sensorspule unterliegt keinerlei Drift.

Eine bevorzugte Ausführungsform kann so konstruiert sein, dass der Nebenschluss-Teil U-förmig ausgebildet ist und an jedem Schenkel jeweils eine Sensorspule angeordnet ist. Durch entsprechende Verschaltung der beiden Sensorspulen können Störeinflüsse verringert werden.

Um aus dem Sensorsignal auf möglichst einfache Weise die geradzahligen Harmonischen, welche den Gleichfluss-Anteil im Kern abbilden, zu extrahieren, ist es günstig, wenn in der Auswerteeinrichtung eine Digitalisierung des Sensorsignals durchgeführt wird, wobei in äquidistanten Zeitpunkten mit einer Abtastfrequenz abgetastet wird, die einem ganzzahligen Vielfachen der Netzfrequenz des Transformators entspricht.

Zur Unterdrückung der im Messsignal der Sensorspule vorhandenen netzfrequenten Signalanteile kann mit Vorteil ein an sich bekanntes Kerbfilter verwendet werden. Dadurch können die netzfrequenten Signalanteile weitgehend unterdrückt werden. Ein Kerbfilter kann sowohl in digitaler Bauform als auch in analoger Bauform hergestellt sein.

Eine besonders bevorzugte Anwendung des erfindungsgemäßen Verfahrens beziehungsweise der erfindungsgemäßen Vorrichtung ist die Unterdrückung von Betriebsgeräuschen bei Leistungstransformatoren. Die Erfindung macht es möglich, dass ein magnetisches Gleichfeld im Kern des Transformators technisch einfach und zugleich zuverlässig über einen langen Betriebszeitraum erfasst werden kann. In Verbindung mit einer am Transformator zusätzlich eingebrachten Kompensationswicklung und eine Einrichtung zur Erzeugung eines Kompensationsstroms, kann in an sich bekannter Weise der die Unsymmetrie verursachende Gleichfluss wirkungslos gemacht werden. Die vorliegende Erfindung ermöglicht eine einfache und in Betrieb zuverlässige Erfassung der relevanten magnetischen Kenngröße im Kern, die eine Voraussetzung für eine wirksame Kompensation ist.

Die Erfindung ermöglicht fernerhin auf einfache Weise eine Registrierung des magnetischen Flusses im Transformatorkern, so dass während des Betriebs auftretende Belastungszustände überwacht und aufgezeichnet werden können (Monitoring).

Das der Erfindung zu Grunde liegende Messprinzips kann auch mit Vorteil bei der Herstellung weichmagnetischer Kerne für elektrische Maschinen gesehen werden. Bei der Herstellung von Transformatoren, wie sie in Energieversorgungsnetzen eingesetzt werden, können qualitative Eigenschaften des geschichteten Magnetkerns während der Produktion erfasst und überwacht werden.

Eine weitere Anwendungsmöglichkeit der vorliegenden Erfindung kann in ein mobiles oder stationäres Messgerätes für magnetische Kenngrößen sein.

Kurzbeschreibung der Zeichnungen

Zur weiteren Erläuterung der Erfindung wird im nachfolgenden Teil der Beschreibung auf die Zeichnungen Bezug genommen in denen weitere vorteilhafte Ausgestaltungen, Einzelheiten und Weiterbildungen der Erfindung zu entnehmen sind.

Figur 1 ist eine schematische Darstellung eines Transformators, in welcher eine mögliche Anordnung der erfindungsgemäßen Vorrichtung zur Detektion eines Gleichfluss-Anteils im Kern und die Signalverarbeitungseinheit als Blockschaltbild skizziert ist;

Figur 2 ist eine schematische Zeichnung, welche in einer vergrößerten Darstellung den Nebenschluss-Teil zeigt, der als magnetischer Shunt fungiert indem er einen Bypass zur magnetischen Hauptflussrichtung bildet.

Ausführung der Erfindung

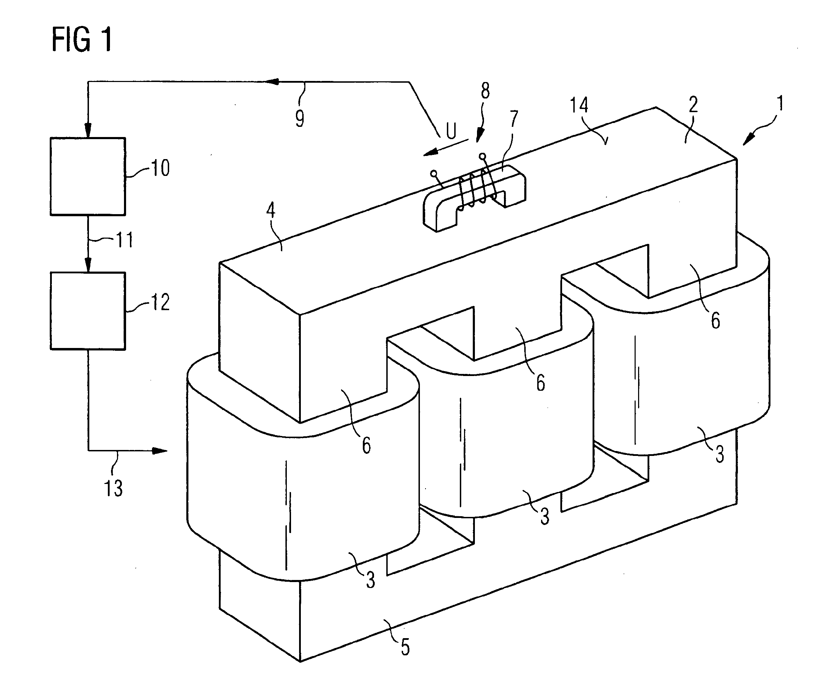

Figur 1 zeigt in einer schematischen perspektivischen Darstellung einen Transformator 1, der mit einer erfindungsgemäßen Vorrichtung zur Detektion eines magnetischen Gleichanteils versehen ist. Die Detektion des Gleichanteils ist eine Voraussetzung, um der durch einen Gleichfluss-Anteil (DC-Anteil) und der damit einhergehenden unsymmetrischen Aussteuerung des magnetischen Werkstoffs des wirkungsvoll entgegen zu wirken. Bei Betrieb auftretende Geräusche und lokale Erwärmung können dadurch reduziert werden.

Der Transformator 1 besitzt einen Kern 2, der drei Schenkel 6 aufweist. Jeder dieser Schenkel 6 trägt eine Wicklungsanordnung 3. Die drei Schenkel 6 sind in üblicher Bauweise oben mit einem oberen Joch 4 und unten mit einem unteren Joch 5 verbunden. Gemäß der Erfindung ist an einem freiliegenden Abschnitt der Oberfläche 14 des oberen Jochteils 4 ein so genanntes Nebenschluss-Teil 7 direkt anliegend oder in einem Abstand angeordnet. Dieses Nebenschluss-Teil 7 dient dem Zwecke der Erfassung des Gleichfluss-Anteils im Kern 2.

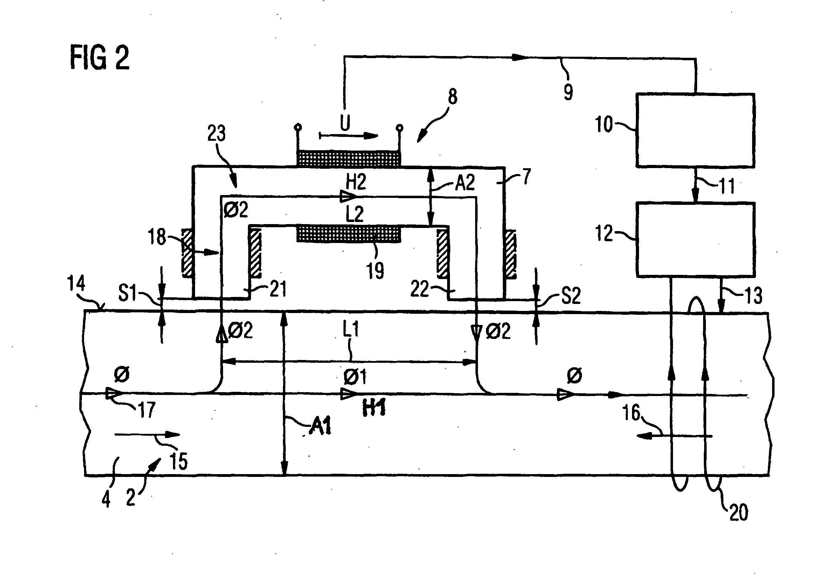

Der Nebenschluss-Teil 7, dessen Funktion unten stehend näher erläutert wird, liefert ein Sensorsignal 9 an eine Auswerteeinrichtung 10. Die Auswerteeinrichtung 10 erzeugt ein Steuersignal 11, welches einer nachgeschalteten Kompensationsstrom-Erzeugungseinrichtung 12 zugeführt ist. Die Kompensationsstrom-Erzeugungseinrichtung 12 erzeugt nach Maßgabe des zugeführten Steuersignals 11 einen Kompensationsstrom 13, welcher in die Kompensationswicklung 20 (Figur 2) des Transformators 1 eingespeist wird. Der Kompensationsstrom 13 wird dabei in Größe und Richtung so vorgegeben, dass er dem Gleichanteil 15 des magnetischen Flusses im Kern 2 des Transformators 1 entgegengewirkt beziehungsweise diesen kompensiert.

In Figur 2 ist der Nebenschluss-Teil 7 in einer vergrößerten Darstellung zu sehen. Der Nebenschluss-Teil 7 ist zu einem Abschnitt am oberen Joch 4 des Transformators 2 etwa parallel liegend angeordnet. Er führt einen Bruchteil des magnetischen Flusses 17, der im oberen Jochteil 4 des Transformators 1 fließt. Im Falle einer Sättigung kommt es zu einem Anstieg des Streuflusses und damit auch zu einem Anstieg des im Nebenschluss geführten Flussanteils.

Wie Figur 2 zeigt, wird mit Hilfe des Nebenschluss-Teils 7 vom Hauptfluss der elektrischen Maschine ein Teil 18 ($\Phi 2$) des magnetischen Flusses abgezweigt und in einem "magnetischen Bypass" geführt. Dabei führt der Pfad dieses abgezweigten magnetischen Flusses 18 ($\Phi 2$) an der Abzweigungsstelle zunächst über einen Luftspalt S1 in einen ersten Schenkel 21 des Nebenschluss-Teils 7. Über einen mittleren Abschnitt gelang der abgezweigte Fluss zu einem zweiten Schenkel 22. Von dort tritt der abgezweigte Teilfluss $\Phi 2$ über den Luftspalt S2 wieder in den oberen Jochteil 4 ein. Nach Vereinigung mit dem magnetischen Fluss $\Phi 1$ des Überbrückungsabschnittes L1 ergibt sich wieder der Hauptfluss $\Phi$.

In Figur 2 ist zu jedem dieser magnetischen Flussanteile $\Phi 1$ und $\Phi 2$ die jeweils dazugehörige magnetische Erregung mit H1 und H2, der Weg im Eisen mit L1 und L2 und die jeweilige Querschnittsfläche mit A1 und A2 bezeichnet. Mit dem Pfeil 15 ist der Gleichanteil des magnetischen Flusses gekennzeichnet, der sich dem Haupt-Wechselfluss 17 überlagert.

Es lässt sich durch Anwendung des Durchflutungsgesetzes zeigen, dass der magnetische Fluss $\Phi$ im Sensor, also im Nebenschlusszweig 23, sich direkt proportional zur magnetischen Erregung H im vom Sensor überdeckten Bereich des Messobjektes verhält.

$$\Phi_2 = [(\mu_0 \,.\, L_1 \,.\, A_2) \,/\, S'] \,.\, H_1$$

Dabei bedeutet

$$S' := [S + (L_2 / \mu_{R2})]$$

mit der Gesamtluftspaltlänge S = S1 + S 2 und mit der relativen Permeabilität des Nebenschluss-Teils $\mu_{R2}$.

Da elektrische Transformatoren und andere elektrische Maschinen üblicher Weise von sinusförmigen Spannungsquellen mit niedriger Quellimpedanz betrieben werden, kann aufgrund des Induktionsgesetzes der Verlauf der ersten Ableitung des magnetischen Flusses $\Phi$ (direkt proportional zur Quellenspannung) und daraus unmittelbar folgend auch dessen Integral, also der magnetische Fluss $\Phi$ selber und daher auch die magnetische Flussdichte bzw. Induktion B, als weitgehend sinusförmig angenommen werden. Bei dem Auftreten von magnetischen Sättigungseffekten muss nun aufgrund der stark abnehmenden Permeabilität des Magnetmaterials die magnetische Erregung H wesentlich erhöht werden, um die geforderte magnetische Flussdichte B zu erlangen. Dies erklärt auch, warum sich magnetische Sättigungseffekte im Vergleich mit der Flussdichte B wesentlich stärker in der magnetischen Erregung H (und somit auch in deren erster Ableitung nach der Zeit) abbilden. Deshalb sind Detektoren vorteilhaft, die ein zur magnetischen Erregung H oder zu deren erster Ableitung dH/dt proportionales Messsignal liefern. Darüber hinaus kann dieses Messverfahren neben dem obig beschriebenen Verwendungszweck auch zum Bau von Messgeräten zur Messung der in einem Prüfling herrschenden magnetischen Erregung H oder darüber hinaus im Zusammenwirken mit einer magnetischen

Flussdichtemessung zur Bestimmung der Magnetisierungskennlinie des verwendeten Magnetmaterials in einem Prüfling benützt werden.

Der magnetische Nebenschlusszweig 23 lässt sich an einem beliebigen Bereich eines Kernabschnitts, zum Beispiel am Joch oder an einem Schenkel mit geringem Aufwand anbringen. Die Auslegung des Transformatorkerns, der elektrischen Wicklung oder andere mechanischer Komponenten ist von diesem Nebenschlusszweig unbeeinflusst.

Das neue Prinzip ermöglicht eine Erfassung des Gleichfluss-Anteils ohne Integration und damit ohne Drift. Das erfindungsgemäße Messeprinzip kann daher auch mit Vorteil für eine Langzeit- Registrierung (Monitoring) eingesetzt werden. Die Herstellungskosten sind gering.

Aufgrund der oben beschriebenen Proportionalität zwischen magnetischer Erregung H im Prüfling und dem magnetischen Fluss $\Phi$ im Sensor entspricht die im Sensor induzierte Spannung dann im Prüfling der ersten Ableitung der magnetischen Erregung nach der Zeit (dH/dt) und kann mit geeigneten Auswerteverfahren über die gesamte Betriebsdauer ein langzeitstabiles Abbild der magnetischen Gleichfeldanteile in einem Transformator oder im Magnetkreis einer elektrischen Maschine liefern.

Von besonderem Vorteil ist die Verwendung von zwei Sensorspulen (in Figur 2 punktiert dargestellt), die jeweils auf eine Schenkel 21, 22 angeordnet sind und elektrisch in Serie geschaltet sind und entlang des magnetischen Nebenschlusszweiges 23 derart angeordnet sind, dass sich einerseits die Wirkung von Fremdfeldern und/oder Streufeldern kompensiert, während sich die Auswirkung des vom Prüfling verursachten magnetischen Flusses $\Phi$ im Sensor im Spannungsmesssignal addieren. Dies kann beispielsweise durch symmetrische Anbringung der beiden Sensorspulen an den jeweiligen Seitenschenkeln eines U-förmigen Sensors erreicht werden.

Durch Einbringung eines so genannten Hallsensors in den magnetischen Nebenschlusskreis 23 des Sensors, beispielsweise in dem oder in einen seiner Luftspalte, kann aufgrund oben erwähnter Proportionalität zwischen magnetischer Erregung H im Prüfling (Messobjekt) und dem magnetischen Fluss $\Phi$ beziehungsweise der magnetischen Induktion B im Sensor ein Messsystem zur direkten Messung der magnetischen Erregung H im vom Sensor überdeckten Bereich des Prüflings realisiert werden. Natürlich kann zu diesem Zweck anstelle eines Hallsensors auch jedes andere dazu äquivalente Messverfahren verwendet werden, dass ein zur Induktion B proportionales Ausgangssignal liefert. Wesentlich ist, dass das Sensorprinzip die magnetische Erregung H im Prüfling (Messobjekt) in einen dazu proportionalen magnetischen Fluss $\Phi$ und somit auch in eine dazu proportionale Flussdichte (Induktion) B im Sensor umsetzt.

Misst man nun obendrein die magnetische Flussdichte (Induktion) B im Prüfling, so kann zusammen mit der oben beschriebenen Messung der im Prüfling herrschenden magnetischen Erregung H ein Messsystem zur Ermittlung der magnetischen Eigenschaften der im Prüfling verwendeten ferromagnetischen Materialien realisiert werden.

Der abgezweigte Flussanteil 18 ($\Phi$2) durchsetzt die Sensorspule 19, welche um einen, die beiden Schenkel 21, 22 verbindenden mittleren Teil des C-förmigen Nebenschluss-Teils 7 gewickelt ist oder in Form von zwei in Serie geschalteten Teilspulen realisiert ist, die jeweils an den beiden Sensorschenkeln angeordnet sind. In dieser Sensorspule 19 wird bei Betrieb des Transformators 1 eine Sensorspannung 8 (in Figur 2 auch mit U bezeichnet) induziert. Diese Sensorspannung 8 wird über eine elektrische Leitung als Sensorsignal 9 einer Auswerteeinrichtung 10 zugeführt.

In der Auswerteeinrichtung 10 wird dieses Sensorsignal zunächst aufbereitet, indem es verstärkt und in einem Tiefpassfilter und einem Bandbreitenfilter gefiltert wird. Bei der Auswertung des Sensorsignals 9 hinsichtlich eines Gleichanteils (DC-Anteils) ist dabei bekanntlich die erste Oberschwingung, das heißt die zweite Harmonische. Aufgrund der "Halbwellen-Unsymmetrie" muss der Magnetisierungsstrom geradzahlige Harmonische aufweisen. Diese geradzahligen Anteile finden sich auch in der Sensorspannung der Messspule 19. Diesen Effekt nützt die vorliegende Erfindung durch eine entsprechende Signalverarbeitung der induzierten Spannung in der Messspule 19.

Im Folgenden wird die Signalverarbeitung der Auswerteeinrichtung 10 näher erläutert:

Zur Unterdrückung der im Sensorsignal dominant vorhandenen netzfrequenten Signalanteile wird ein so genanntes Kerbfilter verwendet, welches diese netzfrequenten Signalanteile weitestgehend unterdrückt. Das Kerbfilter kann sowohl in analoger wie auch in digitaler Technik realisiert sein.

Anschließend erfolgt eine Digitalisierung des Sensorsignals mittels eines herkömmlichen Analog-Digital-Wandlers. Die Abtastung des Signals erfolgt mit einer Abtastfrequenz, die exakt einem geradzahligen vielfachen der Netzfrequenz entspricht. Die Abtastfrequenz wird mittels einer analogen oder digitalen PLL im Zusammenwirken mit einem gesteuerten Oszillator erzeugt.

Anschließend, zusätzlich oder alternativ zum obigen Kerbfilter erfolgt in der Auswerteeinrichtung eine Addition des aktuellen digitalen Signalwertes mit einem, exakt eine halbe Periodendauer der Netzfrequenz zurückliegenden digitalen Signalwert.

Im Ergebnis liefert die Auswerteeinrichtung 10 ein Steuersignal 11, welches in einem funktionalen Zusammenhang zu dem zu bestimmenden magnetischen Gleichfeld 15 des Transformators 1 steht.

Zwischen den Stirnflächen der beiden Schenkel 21, 22 und einer Oberfläche 14 des Kerns 2 ist jeweils ein Spalt S1 und S2 ausgebildet. Jeder Spalt S1, S2 ist so ausgebildet, dass jeder dem magnetischen Fluss 18 einen vergleichsweise hohen Widerstand entgegen setzt. Durch diese nicht ferromagnetische Ausbildung des Spalts S1, S2 wird erreicht, dass in jenen Halbwellen der Aussteuerung, in denen der Magnetwerkstoff des Kerns 2 bereits in die Sättigung kommt, die ferromagnetische Legierung des Nebenschluss-Teils 7 noch nicht gesättigt ist. Mit anderen Worten, die Erfindung macht sich die Eigenschaft zu Nutze, dass im Messobjekt beim Auftreten magnetischer Sättigungseffekte die relative Permeabilität abnimmt und sich dadurch der magnetische Widerstand erhöht. Dies hat dann einen Anstieg des magnetischen Streufeldes zur Folge, da der magnetische Widerstand des Streufeldes unverändert bleibt. Das heißt, dass im Falle beginnender magnetischer Sättigung ein weiterer Anstieg des magnetischen Flusses anteilsmäßig weniger vom Eisenkern des Transformators getragen wird somit ein erhöhter Streufluss auftreten muss. Ist im Kern des Transformators ein Gleichfeld-Anteil vorhanden, so tritt dieser" Verschiebungseffekt" der anteilsmäßig Streufelderhöhung nur in jener Halbperiode auf, bei der sich der magnetische Gleichfluss und Wechselfluss additiv überlagern.

Der Nebenschluss-Teil 7 kann aus gestapelten Blechen einer ferromagnetischen Legierung oder auf Ferritbasis hergestellt und konstruktiv derart ausgelegt sein, dass der Nebenschluss-Teil 7 selbst im Falle starker magnetischer Sättigung des Prüflings 2 (Messobjektes) noch immer frei von magnetischen Sättigungseffekten ist. Die beiden Schenkel 21, 22 können zwecks Aufnahme von zwei Sensormessspulen bezüglich des Querschnittes auch gestuft ausgebildet sein. Um die einzelnen Leiter der Messspule vor mechanischen Beschädigungen zu schützen, kann zwischen der oder den Messspulen und dem Blechpaket ein Träger aus einem Isolator vorgesehen sein. Die Messspule(n) selbst kann (können) aus herkömmlichem lackisolierten Rund- oder Flachdraht bestehen.

Im oben dargestellten Ausführungsbeispiel ist der Nebenschluss-Teil 7 U-förmig ausgeführt. Es versteht sich, dass der Nebenschluss-Teil 7 auch eine andere geometrische Formen aufweisen kann, beispielsweise abgerundet, C-förmig, oder kreisförmig.

Die Anordnung des Nebenschluss-Teils 7 am oberen Joch 4 ist beispielhaft gewählt. Grundsätzlich kommt hierfür jeder frei liegende Bereich an der Oberfläche 14 des Kerns 2 infrage, der den Hauptfluss führt. Der Nebenschluss-Teil 7 kann also auch am Schenkel 6 oder am unteren Jochteil 5 angeordnet werden.

Das oben am Beispiel eines Transformatorkerns erläuterte Messprinzips kann auch bei einem Messgerät Anwendung finden, dass beispielsweise in der Qualitätskontrolle bei der Herstellung geschichteter Kerne für elektrische Maschinen zum Einsatz kommen kann.

Zusammenstellung der verwendeten Bezugszeichen

| | |
|---|---|
| 1 | Transformator |
| 2 | Kern |
| 3 | elektrische Wicklung |
| 4 | oberes Joch |
| 5 | unteres Joch |
| 6 | Schenkel |
| 7 | Nebenschluss-Teil |
| 8 | Sensoreinrichtung (Detektor) |
| 9 | Sensorsignal |
| 10 | Auswerteeinrichtung |
| 11 | Steuersignal |
| 12 | Kompensationsstrom-Erzeugungseinrichtung |
| 13 | Kompensationsstrom |
| 14 | Oberfläche des Kern |
| 15 | Gleichanteil |
| 16 | Kompensationsflussss |
| 17 | Hauptfluss |
| 18 | abgezweigter Teil des magnetischen Flusses |
| 19 | Sensorspule |
| 20 | Kompensationswicklung |
| 21 | Schenkel |
| 22 | Schenkel |
| 23 | Nebenschlusszweig |
| S1 | erster Luftspalt |
| S2 | zweite Luftspalt |
| A1 | Querschnittsfläche im Nebenschluss-Teil 7 |
| A1 | Querschnittsfläche im Joch 4 |
| L1 | magnetische Weglänge im Joch 4 |
| L2 | magnetische Weglänge im Nebenschluss-Teil 7 |

## Patentansprüche

1. Verfahren zum Detektierten einer magnetischen Kenngröße, insbesondere der magnetischen Feldstärke (H1) in einem Abschnitt (L1) eines von einem magnetischen Fluss durchflossenen Kerns (2),

a. wobei ein Teil (18) des magnetischen Flusses vom Kern (2) abgezweigt und über einen magnetischen Nebenschlusszweig (23) geführt wird, in welchem zumindest ein nicht ferromagnetischer Spalt (S1, S2) ausgebildet ist,
b. wobei im Nebenschlusszweig (23) ein Nebenschluss-Teil (7) angeordnet ist, wobei der Magnetwerkstoff des Nebenschluss-Teils (7) nicht gesättigt wird,
c. wobei mindestens ein Abschnitt des Nebenschluss-Teils (7) mit mindestens einer Sensorspule (19) umwickelt ist, in welcher oder in welchen der abgezweigten Teil (18) des magnetischen Flusses durch Induktion ein Sensorsignal (9) erzeugt, und
d. wobei mittels einer Sensor- und Auswerteeinrichtung (8, 10), der das Sensorsignal (9) zugeführt ist, aus diesem abgezweigten Teil (18) des magnetischen Flusses oder einer davon abgeleiteten Größe die magnetische Kenngröße (H1) ermittelt wird.

2. Verfahren nach Anspruch 1, **dadurch gekennzeichnet, dass** der Nebenschlusszweig (23), über den der abgezweigte Teil (18) des magnetischen Flusses geführt wird, eine effektive Permeabilität aufweist, die kleiner als die Permeabilität des Kerns (2) ist.

3. Verfahren nach Anspruch 1 oder 2, **dadurch gekennzeichnet, dass** mittels der Auswerteeinrichtung (10) aus dem Sensorsignal (9) ein Gleichanteil des magnetischen Flusses ermittelt wird.

4. Verfahren nach Anspruch 3, **dadurch gekennzeichnet, dass** in der Auswerteeinrichtung (10) mittels eines Kerbfilters ein netzfrequenter Grundschwingungsanteil eliminiert wird, und eine Digitalisierung des Sensorsignals (19) durchgeführt wird, wobei in äquidistanten Zeitpunkten mit einer Abtastfrequenz abgetastet wird, die einem ganzzahligen Vielfachen der Netzfrequenz des Transformators entspricht.

5. Verfahren nach Anspruch 4, **dadurch gekennzeichnet, dass** digitale Signalwerte mit einem jeweils eine halbe Periodendauer der Netzfrequenz zurückliegenden digitalen Signalwert addiert werden.

6. Verfahren nach Anspruch 4, **dadurch gekennzeichnet, dass** aus den digitalen Signalwerten mittels eines Bandpass-Filters Signalanteile mit doppelter Netzfrequenz herausgefiltert werden und die herausgefilterten Signalwerte einer Fouriertransformation unterzogen werden.

7. Vorrichtung zum Detektierten einer magnetischen Kenngröße, insbesondere der magnetischen Feldstärke (H1) in einem Abschnitt (L1) eines von einem magnetischen Fluss durchflossenen Kerns (2), wobei ein Teil (18) des magnetischen Flusses vom Kern (2) abgezweigt und über einen magnetischen Nebenschlusszweig (23) geführt ist umfassend:

- einen magnetischen Nebenschluss-Teil (7), der im Nebenschlusszweig (23) angeordnet ist und den vom Kern (2) abgezweigten Teil (18) des magnetischen Flusses führt, wobei im Nebenschlusszweig (23) zumindest ein nicht ferromagnetischer Spalt (S1, S2) ausgebildet ist, so dass der Magnetwerkstoff des Nebenschluss-Teils (7) nicht gesättigt wird; und wobei mindestens ein Teil des Nebenschluss-Teils (7) mit mindestens einer Sensorspule (19) umwickelt ist, in welcher oder in welchen der abgezweigte Teil (18) des magnetischen Flusses durch Induktion ein Sensorsignal (9) erzeugt; und
- eine Sensor- und Auswerteeinrichtung (8, 10), der das Sensorsignal (9) zugeführt ist, und die dazu eingerichtet ist, um aus dem abgezweigten Teil (18) des magnetischen Flusses, oder einer davon abgeleiteten Größe, die magnetische Kenngröße (H1) zu ermitteln.

8. Vorrichtung nach Anspruch 7, **dadurch gekennzeichnet, dass** im Nebenschlusszweig (23), in welchem der abgezweigte Teil (18) des magnetischen Flusses geführt wird, die effektive Permeabilität kleiner ist als die Permeabilität im Kern (2).

9. Vorrichtung nach Anspruch 7 oder 8, **dadurch gekennzeichnet, dass** die Auswerteeinrichtung (10) dazu eingerichtet ist, um aus dem zugeleiteten Sensorsignal (9) einen Gleichanteil des magnetischen Flusses zu ermitteln.

10. Vorrichtung nach Anspruch 7 oder 8, **dadurch gekennzeichnet, dass** der magnetische Nebenschluss-Teil (7) U-förmig ausgebildet ist und zwei Schenkel 21,22 aufweist, auf denen jeweils eine Sensorspule (19) angeordnet ist, die elektrisch in Serie geschaltet sind und räumlich im Nebenschlusszweig (23) derart angeordnet sind, dass sich die Wirkung von Fremdfeldern kompensiert, während sich die vom abgezweigten Teil (18) des magnetischen Flusses hervorgerufene induzierte elektrische Spannung addiert.

**11.** Vorrichtung nach einem der Ansprüche 7 bis 9, **dadurch gekennzeichnet, dass** die Auswerteeinrichtung (10) ein Kerbfilter aufweist, welche so eingerichtet ist, dass sie aus dem Sensorsignal (9) einen netzfrequenten Grundschwingungsanteil eliminiert.

**12.** Vorrichtung nach Anspruch 11, dadurch-gekennzeichnet, dass die Auswerteeinrichtung (10) dazu eingerichtet ist, eine Digitalisierung des Sensorsignals (9) durchzuführen, wobei in äquidistanten Zeitpunkten mit einer Abtastfrequenz abgetastet wird, die ein ganzzahliges Vielfaches der Netzfrequenz ist.

**13.** Vorrichtung nach Anspruch 11, **dadurch gekennzeichnet, dass** die Auswerteeinrichtung (10) so ausgebildet ist, dass digitale Signalwerte jeweils mit einem eine halbe Periodendauer der Netzfrequenz zurückliegenden digitalen Signalwert addiert werden.

**14.** Vorrichtung nach Anspruch 11, **dadurch gekennzeichnet, dass** die Auswerteeinrichtung (10) mit einem Bandpass-Filter ausgestattet ist, um aus den digitalen Signalwerten Signalanteile mit doppelter Netzfrequenz herauszufiltern.

**15.** Vorrichtung nach Anspruch 11, **dadurch gekennzeichnet, dass** die Auswerteeinrichtung (10) fernerhin mit einer Recheneinrichtung ausgestattet ist, mittels derer aus herausgefilterten Signalwerten eine Fouriertransformation berechenbar ist.

**16.** Vorrichtung nach einem der Ansprüche 7 bis 15, **dadurch gekennzeichnet, dass** der Nebenschluss-Teil (7) aus einem Paket geschichteter C-förmiger ferromagnetischer Bleche gebildet ist.

**17.** Vorrichtung nach Anspruch 16, **dadurch gekennzeichnet, dass** die C-förmigen Bleche erste Schenkel (21) und zweite Schenkel (22) aufweisen und die Anordnung zum Kern (2) so gewählt ist, dass jeder dieser Schenkel (21, 22) zwischen einer zum Kern weisenden Stirnfläche und der Oberfläche (14) des Kerns (2) jeweils einen Spalt (S1, S2) ausbildet.

**18.** Anwendung des Verfahrens nach einem der Ansprüche 1 bis 6, oder der Vorrichtung nach einem der Ansprüche 7 bis 17 bei einem in ein Energieversorgungsnetz eingebundenen Transformator, um im Kern (2) des Transformators einem Gleichfluss-Anteil entgegen zu wirken und/oder den Betriebszustand des Transformators zu registrieren.

## Claims

**1.** Method for detecting a magnetic characteristic variable, in particular the magnetic field intensity (H1) in a section (L1) of a core (2) through which a magnetic flux flows,

a. wherein part (18) of the magnetic flux is branched off from the core (2) and is guided via a magnetic shunt branch (23) in which at least one non-ferromagnetic gap (S1, S2) is formed,
b. wherein a shunt part (7) is disposed in the shunt branch (23), wherein the magnetic material of the shunt part (7) is not saturated,
c. wherein at least one section of the shunt part (7) is wrapped with at least one sensor coil (19) in which the branched-off part (18) of the magnetic flux generates a sensor signal (9) through induction, and
d. wherein the magnetic characteristic variable (H1) is determined from this branched-off part (18) of the magnetic flux or from a variable derived therefrom, by means of a sensor and evaluation device (8, 10) to which the sensor signal (9) is sent.

**2.** Method according to claim 1, **characterised in that** the shunt branch (23) via which the branched-off part (18) of the magnetic flux is guided has an effective permeability which is less than the permeability of the core (2).

**3.** Method according to claim 1 or 2, **characterised in that** a unidirectional component of the magnetic flux is determined from the sensor signal (9) by means of the evaluation unit (10).

**4.** Method according to claim 3, **characterised in that** a line-frequency fundamental component is eliminated in the evaluation device (10) by means of a notch filter, and a digitisation of the sensor signal (19) is performed, wherein sampling takes place at equidistant points in time with a sampling frequency which corresponds to an integral multiple of the line frequency of the transformer.

5. Method according to claim 4, **characterised in that** digital signal values are totalled, each with a digital signal value half a period interval behind the line frequency.

6. Method according to claim 4, **characterised in that** signal components at twice the line frequency are filtered out from the digital signal values by means of a bandpass filter and the filtered-out signal values are subjected to a Fourier transformation.

7. Apparatus for detecting a magnetic characteristic variable, in particular the magnetic field intensity (H1) in a section (L1) of a core (2) through which a magnetic flux flows, wherein part (18) of the magnetic flux is branched off from the core (2) and is guided via a magnetic shunt branch (23) comprising:

- a magnetic shunt part (7) which is disposed in the shunt branch (23) and guides the part (18) of the magnetic flux which is branched off from the core (2), wherein at least one non-ferromagnetic gap (S1, S2) is formed in the shunt branch (23), so that the magnetic material of the shunt part (7) is not saturated; and wherein at least one part of the shunt part (7) is wrapped with at least one sensor coil (19) in which the branched-off part (18) of the magnetic flux generates a sensor signal (9) through induction, and
- a sensor and evaluation device (8, 10) to which the sensor signal (9) is sent, and which is set up to determine the magnetic characteristic variable (H1) from the branched-off part (18) of the magnetic flux or from a variable derived therefrom.

8. Apparatus according to claim 7, **characterised in that** the effective permeability is less than the permeability in the core (2) in the shunt branch (23) in which the branched-off part (18) of the magnetic flux is guided.

9. Apparatus according to claim 7 or 8, **characterised in that** the evaluation device (10) is set up to determine a unidirectional component of the magnetic flux from the sensor signal (9) supplied.

10. Apparatus according to claim 7 or 8, **characterised in that** the magnetic shunt part (7) is U-shaped and comprises two legs (21, 22), on each of which a sensor coil (19) is disposed, which are electrically connected in series and are spatially arranged in the shunt branch (23) such that the effect of external fields is compensated for, while the induced electrical voltage caused by the branched-off part (18) of the magnetic flux is totalled.

11. Apparatus according to one of claims 7 to 9, **characterised in that** the evaluation device (10) has a notch filter which is set up such that it eliminates a line-frequency fundamental component from the sensor signal (9).

12. Apparatus according to claim 11, **characterised in that** the evaluation device (10) is set up to perform a digitisation of the sensor signal (9), wherein sampling takes place at equidistant points in time with a sampling frequency which is an integral multiple of the line frequency.

13. Apparatus according to claim 11, **characterised in that** the evaluation device (10) is designed such that digital signal values are totalled, each with a digital signal value half a period interval behind the line frequency.

14. Apparatus according to claim 11, **characterised in that** the evaluation device (10) is equipped with a bandpass filter to filter out signal components at twice the line frequency from the digital signal values.

15. Apparatus according to claim 11, **characterised in that** the evaluation device (10) is furthermore equipped with a computing device, by means of which a Fourier transformation can be calculated from filtered-out signal values.

16. Apparatus according to one of claims 7 to 15, **characterised in that** the shunt part (7) is formed from a packet of laminated C-shaped ferromagnetic plates.

17. Apparatus according to claim 16, **characterised in that** the C-shaped plates have first legs (21) and second legs (22) and the arrangement to the core (2) is selected such that each of these legs (21, 22) forms a gap (S1, S2) between an end surface pointing to the core and the surface (14) of the core (2).

18. Application of the method according to one of claims 1 to 6, or of the device according to one of claims 7 to 17 in the case of a transformer incorporated into a power supply grid, in order to counter a unidirectional flux component in the core (2) of the transformer and/or to record the operating state of the transformer.

## Revendications

1. Procédé de détection d'une grandeur caractéristique magnétique, en particulier l'intensité de champ magnétique (H1) dans une section (L1) d'un noyau (2) traversé par un flux magnétique,

   a. dans lequel une partie (18) du flux magnétique est séparée du noyau (2) et est guidée via un élément en dérivation magnétique (23), dans lequel au moins un interstice non ferromagnétique (S1, S2) est formé,
   b. dans lequel dans l'élément en dérivation (23) est disposée une pièce en dérivation (7), dans lequel la matière magnétique de la pièce en dérivation (7) n'est pas saturée,
   c. dans lequel au moins une section de la pièce en dérivation (7) est entourée avec au moins un enroulement de détection (19), dans lequel ou dans lesquels la partie (18) du flux magnétique séparée génère un signal de détection (9) par induction, et
   d. dans lequel au moyen d'un dispositif de détection et d'interprétation (8, 10) auquel est amené le signal de détection (9), la grandeur caractéristique magnétique (H1) est déterminée à partir de cette partie (18) du flux magnétique séparée ou d'une grandeur qui en est dérivée.

2. Procédé selon la revendication 1, **caractérisé en ce que** l'élément en dérivation (23), par le biais duquel la partie (18) du flux magnétique séparée est guidée, présente une perméabilité effective qui est inférieure à la perméabilité du noyau (2).

3. Procédé selon la revendication 1 ou 2, **caractérisé en ce que**, au moyen du dispositif d'interprétation (10), une composante continue du flux magnétique est déterminée à partir du signal de détection (9).

4. Procédé selon la revendication 3, **caractérisé en ce que** dans le dispositif d'interprétation (10) au moyen d'un filtre coupe-bandes une composante d'amplitude fondamentale de la fréquence du réseau est éliminée, et une numérisation du signal de détection (19) est réalisée, au cours de laquelle un balayage est effectué à des moments équidistants par une fréquence de balayage qui correspond à un multiple entier de la fréquence du réseau du transformateur.

5. Procédé selon la revendication 4, **caractérisé en ce qu'**aux valeurs de signaux numériques est ajoutée une valeur de signal numérique passé correspondant respectivement à la moitié de la durée de période de la fréquence du réseau.

6. Procédé selon la revendication 4, **caractérisé en ce qu'**à partir des valeurs de signaux numériques des composantes de signaux ayant une fréquence de réseau doublée sont identifiées au moyen d'un filtre passe-bandes et les valeurs de signaux identifiées sont soumises à une transformation de Fourier.

7. Dispositif de détection d'une grandeur caractéristique magnétique, en particulier l'intensité de champ magnétique (H1) dans une section (L1) d'un noyau (2) traversé par un flux magnétique, dans lequel une partie (18) du flux magnétique est séparée du noyau (2) et est guidée via un élément en dérivation magnétique (23), comprenant :

   - une pièce en dérivation magnétique (7), qui est disposée dans l'élément en dérivation magnétique (23) et guide la partie (18) du flux magnétique séparée du noyau (2), dans lequel au moins un interstice non ferromagnétique (S1, S2) est formé dans l'élément en dérivation magnétique (23), de sorte que la matière magnétique de la pièce en dérivation (7) n'est pas saturée ; et dans lequel au moins une partie de la pièce en dérivation (7) est entourée avec au moins un enroulement de détection (19), dans lequel ou dans lesquels la partie (18) du flux magnétique séparée génère un signal de détection (9) par induction, et
   - un dispositif de détection et d'interprétation (8, 10) auquel est amené le signal de détection (9) et qui est conçu pour déterminer la grandeur caractéristique magnétique (H1) à partir de la partie (18) du flux magnétique séparée, ou d'une grandeur qui en est dérivée.

8. Dispositif selon la revendication 7, **caractérisé en ce que** dans l'élément en dérivation (23), dans lequel la partie (18) du flux magnétique séparée est guidée, la perméabilité effective est inférieure à la perméabilité dans le noyau (2).

**9.** Dispositif selon la revendication 7 ou 8, **caractérisé en ce que** le dispositif d'interprétation (10) est conçu pour déterminer une composante continue du flux magnétique à partir du signal de détection (9) amené.

**10.** Dispositif selon la revendication 7 ou 8, **caractérisé en ce que** l'élément en dérivation magnétique (7) est configuré en forme de U et présente deux branches 21, 22, sur lesquelles est respectivement disposé un enroulement de détection (19), qui sont montées électriquement en série et disposées dans l'espace dans l'élément en dérivation (23) de telle sorte que l'effet de champs d'excitation indépendants est compensé, tandis que la tension électrique induite engendrée par la partie (18) du flux magnétique séparée s'ajoute.

**11.** Dispositif selon l'une des revendications 7 à 9, **caractérisé en ce que** le dispositif d'interprétation (10) présente un filtre coupe-bandes, qui est conçu de sorte qu'il élimine du signal de détection (9) une composante d'amplitude fondamentale de la fréquence du réseau.

**12.** Dispositif selon la revendication 11, **caractérisé en ce que** le dispositif d'interprétation (10) est conçu pour réaliser une numérisation du signal de détection (9), au cours de laquelle un balayage est effectué à des moments équidistants par une fréquence de balayage qui est un multiple entier de la fréquence du réseau.

**13.** Dispositif selon la revendication 11, **caractérisé en ce que** le dispositif d'interprétation (10) est configuré de sorte qu'aux valeurs de signaux numériques est ajoutée une valeur de signal numérique passé correspondant respectivement à la moitié de la durée de période de la fréquence du réseau.

**14.** Dispositif selon la revendication 11, **caractérisé en ce que** le dispositif d'interprétation (10) est équipé d'un filtre passe-bandes pour identifier à partir des valeurs de signaux numériques des composantes de signaux ayant une fréquence de réseau doublée.

**15.** Dispositif selon la revendication 11, **caractérisé en ce que** le dispositif d'interprétation (10) est en outre équipé d'un dispositif de calcul au moyen duquel une transformation de Fourier est calculable à partir des valeurs de signaux identifiées.

**16.** Dispositif selon l'une des revendications 7 à 15, **caractérisé en ce que** la pièce en dérivation (7) est formée à partir d'un paquet de tôles ferromagnétiques en forme de C empilées.

**17.** Dispositif selon la revendication 16, **caractérisé en ce que** les tôles en forme de C présentent des premières branches (21) et des deuxièmes branches (22) et la disposition par rapport au noyau (2) est choisie de sorte que chacune de ces branches (21, 22) forme respectivement un interstice (S1, S2) entre une surface frontale orientée vers le noyau et la surface (14) du noyau (2).

**18.** Utilisation du procédé selon l'une des revendications 1 à 6, ou du dispositif selon l'une des revendications 7 à 17 dans un transformateur intégré à un réseau de distribution d'électricité, pour faire agir en sens contraire une composante de flux continu dans le noyau (2) du transformateur et/ou enregistrer l'état opérationnel du transformateur.

FIG 1
1
2
14
7
8
U
9
4
6
6
6
3
3
3
5
10
11
12
13

FIG 2
U
8
9
10
11
12
13
7
A2
H2
L2
19
23
Ø2
21
22
18
S1
S2
14
Ø
17
15
2
4
L1
Ø1
H1
A1
16
20

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 4021860 C2
- EP 2007055728 W
- JP 570434006 B
- US 2007159284 A
- WO 2008151661 A
- DE 102006037003
- US 3863109 A
- WO 0143267 A